# EUROPÄISCHE PATENTSCHRIFT

(11) **EP 1 678 992 B1**
(45) Veröffentlichungstag und Bekanntmachung des Hinweises auf die Patenterteilung: **14.10.2009**
(21) Anmeldenummer: 04791023.7
(22) Anmeldetag: 29.10.2004
(51) Int. Cl.: H05K 3/34

(54) **VERFAHREN ZUM AUFSCHMELZLÖTEN MIT VOLUMENSTROMSTEUERUNG**
METHOD FOR REFLOW SOLDERING WITH VOLUME FLOW CONTROL
PROCEDE DE BRASAGE PAR FUSION A COMMANDE DE DEBIT VOLUMETRIQUE

(30) Priorität: 30.10.2003 DE 10350699
(43) Veröffentlichungstag der Anmeldung: 12.07.2006
(73) Patentinhaber: Rehm Thermal Systems GmbH, 89143 Blaubeuren-Seissen (DE)
(72) Erfinder: BELL, Hans, 89143 Blaubeuren-Seissen (DE)
(74) Vertreter: Grünecker, Kinkeldey, Stockmair & Schwanhäusser Anwaltssozietät
(86) Internationale Anmeldenummer: PCT/EP2004/012262
(87) Internationale Veröffentlichungsnummer: WO 2005/043758

(56) Entgegenhaltungen:
- EP-A- 0 279 604
- EP-A- 1 133 219
- DE-A1- 10 133 217
- DE-A1- 10 256 250
- US-A- 5 553 768
- US-A- 5 560 531
- US-A- 6 005 224
- PATENT ABSTRACTS OF JAPAN Bd. 2000, Nr. 23, 10. Februar 2001 (2001-02-10) & JP 2001 160675 A (OMRON CORP), 12. Juni 2001 (2001-06-12)

## Beschreibung

Die Erfindung betrifft ein Verfahren zum Aufschmelzlöten, das auch als Reflowlöten bezeichnet wird, wobei ein mit Bauelementen bestücktes Lötgut gezielt einer Lötung unterzogen wird, indem eine Lotpaste, die mit den Bauelementen an spezifizierten Stellen in Kontakt ist, nach Vorheizen dann in einer Lötzone verflüssigt wird, um damit den gewünschten Lötkontakt herzustellen.

Bei der industriellen Massenfertigung von Baugruppen mit elektronischen Komponenten müssen in der Regel eine Vielzahl von temperaturempfindlichen Bauelementen mit entsprechenden Kontaktflächen auf einer Leiterplatte verlötet werden. Für diesen Zweck weisen die elektronischen Bauelemente entsprechende Lötflächen, die zum Teil als Drahtanschlüsse oder Kontaktstifte bei konventionellen Bauelementen vorgesehen sind, oder die in Form von Metallflächen an entsprechenden Stellen vorgesehen sind, wie dies bei Bauteilen für die Oberflächenmontage (SMD-Bauteile) der Fall ist. Bei der anhaltenden Miniaturisierung von Baugruppen werden auch die einzelnen Bauelemente ständig kleiner, wobei die Art des Bauteils sowie dessen Verwendungszweck zum Teil eine gewisse minimale Größe vorgeben. Beispielsweise können Widerstände, Dioden und Kleinsignaltransistoren in extrem kleinen Gehäusen hergestellt werden, wohingegen andere Bauelemente, etwa Induktivitäten, Kapazitäten oder Leistungstransistoren in deutlich größeren Gehäusen untergebracht sind. Da in zunehmendem Maße Geräte aller Art elektronisch gesteuert werden, ist in der Regel eine Vielzahl von Bauelementen mit Kleinsignaleigenschaften sowie eine Reihe von Bauteilen mit höherer Leistung oder höherem Volumenbedarf erforderlich. Eine entsprechend gestaltete Baugruppe weist daher in der Regel Bauelemente mit sehr unterschiedlichen Größen und Formen und dementsprechend mit sehr unterschiedlichem thermischen Verhalten auf.

Für eine einwandfreie mechanische und elektrische Verbindung zwischen einem Bauelement, bzw. dessen Metallanschlussfläche, und einer entsprechenden Kontaktfläche auf einer Platine ist eine Verflüssigung der Lotpaste für nicht mehr als ungefähr 60 Sekunden erforderlich, wobei allerdings die Temperatur der einzelnen Bauelemente einer vorgegebenen Temperatur entsprechend den Bauelementspezifikationen nur einer sehr begrenzten Zeit ausgesetzt werden darf. Die Liquidustemperatur typischer Lotpasten liegt im Bereich von 183 bis 227° C, was einer Temperatur entspricht, die für die meisten verwendeten Bauelemente für einen Bereich von mehreren Minuten nicht kritisch ist. Eine Beaufschlagung einer Baugruppe knapp über der Liquidustemperatur würde daher zwar die Gefahr einer Überhitzung kleiner und damit sich schnell erwärmender Bauelemente vermeiden, würde jedoch zu einer langen Lötphase führen, da die Metallflächen an den kleinen Bauteilen bereits die Liquidustemperatur überschritten haben, während die Metallflächen an großen Bauteilen noch keine Verflüssigung der Lotpaste ermöglichen. Eine daraus resultierende sehr lange Lötung für die kleinen Bauteile führt jedoch in der Regel zu einem mangelhaften Lötergebnis und lässt damit diese Technik als wenig attraktiv erscheinen. Eine langsame und damit gleichmäßige Erwärmung aller Bauelemente bis knapp unter die Liquidustemperatur der Lotpaste könnte zwar das oben genannte Problem deutlich verringern, ist jedoch in der Praxis problematisch, da gewisse Aktivatoren in der Lotpaste ihre Funktion vor dem eigentlichen Lötvorgang verlieren und zudem eine unerwünschte Oxidation der zu lötenden Metalloberflächen stattfindet, wodurch die Benetzungsfähigkeit der Lötkontakte mit flüssigem Lot beeinträchtigt wird.

In vielen bekannten Vorrichtungen wird daher in einer Vorheizzone das Lötgut auf eine Temperatur im Bereich von 150 bis 160° (bei Verwendung bleihaltiger Lote) bzw. 160 bis 200° (bei Verwendung bleifreier Lote) aufgeheizt, wobei das Aufheizen so stattfindet, dass sich im Wesentlichen ein Temperaturgleichgewicht in dem Lötgut ausbilden kann. Daraufhin wird das Lötgut in eine Lötzone gebracht, in der dieses mit deutlich höherer Temperatur beaufschlagt wird, so dass zunächst die Bauteile auf eine Temperatur über der Liquidustemperatur der Lotpaste gebracht werden und während der Verflüssigung der Lotpaste der Lötvorgang stattfindet. Da das Aufheizen und der Lötvorgang in einem Zeitfenster von maximal 50 bis 60 Sekunden stattfinden soll, wird dabei in der Regel in der Lötzone mit hohen Temperaturen von 240 bis 300° C gearbeitet. Wie zuvor bereits erwähnt wurde, nehmen in der Regel kleine Bauelemente rascher eine hohe Temperatur an als entsprechend träge und große Bauelemente, so dass bei diesen in der Lötzone herrschenden hohen Temperaturen die Gefahr der Überhitzung kleiner Bauelemente auftritt, was sich in Fehlfunktionen oder frühzeitigem Ausfall der Bauelemente und damit der gesamten Baugruppe auswirken kann. Es werden daher Anstrengungen unternommen, um einerseits ein rasches Aufheizen der Bauelemente über die Liquidustemperatur zu ermöglichen, wobei andererseits jedoch die Gefahr einer Überhitzung kleiner Bauelemente reduziert wird. In diesem Zusammenhang beschreibt die deutsche Patentschrift DE 197 41 192 ein Reflowlötverfahren zum Löten eines Lötgutes in einem Durchlaufofen, wobei das Lötgut in einer Vorheizzone mittels Vorheizeinrichtungen auf eine Temperatur unterhalb der Schmelztemperatur des Lotes gebracht wird und anschließend in einer Lötzone mittels Heizeinrichtungen gelötet wird und darauf folgend in einer Kühlzone auf eine Temperatur unterhalb der Schmelztemperatur abgekühlt wird. Das in der DE 197 41 192 beschriebene Lötverfahren zeichnet sich dadurch aus, dass das Lötgut zunächst in einen ersten Bereich der Lötzone gebracht wird, in dem es mittels einer ersten Konvektionsheizeinrichtung mit einer Temperatur beaufschlagt wird, die deutlich über der Schmelztemperatur des Lotes liegt. Anschließend wird das Lötgut in einen nachfolgenden zweiten Bereich der Lötzone gebracht, in dem das Lötgut mittels einer zweiten Konvektionsheizeinrichtung mit einer niedrigeren Temperatur beaufschlagt wird, die aber noch oberhalb der Schmelztemperatur des Lotes liegt. Dabei soll in diesem beschriebenen Reflowlötverfahren die zunächst hohe erste Temperatur ein Aufheizen insbesondere der kleineren Bauteile über die Liquidustemperatur ermöglichen, wobei in dem nachfolgenden Schritt mit geringerer Temperatur eine Überhitzung der kleineren Bauteile vermieden werden soll, wohingegen die größeren Bauteile weiterhin ihre Temperatur bis zur erforderlichen Liquidustemperatur erhöhen.

Obwohl das zuvor genannte Verfahren zu einem ausgeglicheneren Temperaturverlauf beim Löten von großen und kleinen Bauelementen führen kann, so ist doch die exakte Einstellung der ersten und der zweiten Temperatur sowie die entsprechende Verweilzeit in dem ersten Bereich mit der hohen Temperatur auf die jeweilige Baugruppe anzupassen, da ansonsten die Gefahr besteht, dass in dem ersten Hochtemperaturschritt kleine Bauteile überhitzt werden. Bei der Verarbeitung einer Vielzahl unterschiedlicher Baugruppen ist somit die Maschinenauslastung eingeschränkt, da die Temperatureinstellung für unterschiedliche Baugruppen neu justiert werden muss, oder aber es besteht die Gefahr einer erhöhten Ausfallrate auf Grund einer Überhitzung von kleinen Bauteilen, wenn die gleiche Einstellung für unterschiedliche Baugruppen angewendet wird.

US-A-6005224 beschreibt ein Verfahren zum Löten eines Lotgutes in einem Durchlaufofen mit einer Vorheizzone, einer Lötzone mit Konvektionsheizeinrichtung einer Abkühlzone und einer Steuereinheit, so dass heiße Gase mit einstellbaren Temperaturen und Volumenströmen auf das Lötgut einwirken.

Es ist daher eine Aufgabe der vorliegenden Erfindung, ein Verfahren und eine Vorrichtung zum Aufschmelzlöten von Lötgut bereitzustellen, wobei ein hohes Maß an Flexibili-tät bei Verarbeitung unterschiedlicher Baugruppen gegeben ist und dennoch die Gefahr einer Überhitzung kleiner Bauelemente während des Lötvorganges gering ist.

Erfindungsgemäß wird entsprechend einem Aspekt der vorliegenden Erfindung diese Aufgabe durch ein Verfahren zum Löten eines Lötgutes in einem Durchlaufofen gemäß Anspruch 1 gelöst.

Erfindungsgemäß findet also die Steuerung der effektiven Temperatur der Bauelemente eines Lötgutes unter anderem durch Variieren des Volumenstroms erhitzten Gases statt, so dass eine rasche und feinfühligere Justierung des aktuellen Temperaturprofils der Baugruppe möglich ist im Vergleich zu einer relativ trägen Steuerung der Temperatur, die in der Regel durch Einteilung einer Lötzone in gewisse Bereiche mit konstanter Temperatur in diskreten Schritten gesteuert wird. Dem gegenüber ermöglicht es die erfindungsgemäße Lösung durch Regelung des Volumenstromes und gegebenenfalls der Temperatur innerhalb relativ kurzer Zeiträume und bei Bedarf auch innerhalb eines einzelnen Lötzonenbereichs eine effektive Temperaturprofilierung an der Baugruppe durchzuführen, wobei dann durch die nachfolgende Reduzierung des Volumenstroms in effizienter Weise eine Überhitzung kleiner Bauteile verhindert und ein weiteres Erwärmen größerer Bauteile bewerkstelligt werden kann. Beispielsweise kann ein sehr hoher Volumenstrom bei vorgegebener Temperatur zu Beginn in der Lötzone etabliert werden, wobei die noch nicht verflüssigte Lotpaste aufgrund ihrer Klebkraft für die erforderliche Fixierung der Bauelemente auf der Leiterplatte sorgt und der hohe Volumenstrom ein rasches Erwärmen kleiner und großer Bauteile ermöglicht. Dabei kann die vorgegebene Temperatur des Volumenstroms beispielsweise so gewählt werden, dass eine gewisse kritische Temperatur für die Bauteile nicht überschritten werden kann. Nachfolgend wird der Volumenstrom verringert, beispielsweise vor dem Einsetzen des Verflüssigens der Lotpaste, so dass generell die Temperaturbeaufschlagung aller Bauteile reduziert wird und gleichzeitig die sich an kleinen Bauelementen verflüssigende Lotpaste kaum oder nicht mechanisch durch den jetzt reduzierten Volumenstrom beeinflusst wird. Z. B. kann der Zeitpunkt des Verflüssigens der Lotpaste an einem kleinen Bauteil optisch überwacht werden und eine Verringerung des Volumenstroms kann dann unmittelbar kontinuierlich oder schrittweise ausgeführt werden. Dabei kann die Verringerung des Volumenstroms durch eine entsprechende Ansteuerung von Lüfterelementen in dem gleichen Bereich der Lötzone vorgenommen werden, oder das Lötgut kann in einen weiteren Bereich der Lötzone mit geringerem Volumenstrom transportiert werden.

Gemäß dem erfindungsgemäßen Verfahren findet die Beaufschlagung des Lötgutes mit dem Volumenstrom so statt, dass zunächst das Lötgut mit einem ersten Volumenstrom mit einer ersten Temperatur mittels einer Konvektionsheizeinrichtung beaufschlagt wird und anschließend das Lötgut in der Lötzone mit einem zweiten Volumenstrom mit einer zweiten Temperatur mittels der Konvektionsheizeinrichtung beaufschlagt wird, wobei der erste Volumenstrom größer als der zweite Volumenstrom ist.

Dieses Verfahren ermöglicht eine effiziente Erwärmung großer und kleiner Bauteile des Lötgutes durch die Vorgabe mindestens zweier unterschiedlicher Volumenströme, wobei eine Überhitzung kleiner Bauteile während des geringeren zweiten Volumenstromes wirksam verhindert wird. Ferner ergibt sich durch die Steuerung des Aufheizvorganges mittels des Volumenstromes die Möglichkeit, rasch auf unterschiedlich gestaltete Lötgüter zu reagieren, da in vielen konventionellen mit Konvektionsheizeinrichtungen versehenen Durchlauföfen der Volumenstrom rasch eingestellt werden kann, wobei eine ebenso zügige Neueinstellung der Temperatur des Volumenstroms in der Regel nicht stattfindet. Beispielsweise kann bei einer Erhöhung des Volumenstroms, die beispielsweise notwendig sein kann bei der Bearbeitung von Lötgütern mit einem höheren Anteil an großvolumigen Bauelemente, die Temperatur des Volumenstromes abnehmen auf Grund der Trägheit der Heizung der Konvektionseinrichtung, was jedoch auf Grund des großen Anfangsvolumenstromes sich nicht nachteilig auf die rasche Aufheizung des Lötgutes auswirkt. In ähnlicher Weise kann bei einer Reduzierung des Volumenstromes dessen Temperatur zunächst zunehmen, so dass bei einer rein temperaturgesteuerten Anlage eine entsprechende Zeitdauer zur Erreichung eines Temperaturgleichgewichts abzuwarten ist, wohingegen gemäß der vorliegenden Erfindung ein entsprechend temporärer Anstieg der Temperatur nach Reduzierung des Volumenstromes durch eine geeignete weitere Verringerung des Volumenstromes kompensiert werden kann, so dass die tatsächliche Bauteiltemperatur unterhalb einer geforderten kritischen Temperatur selbst unmittelbar nach einer entsprechenden Umstellung der Anlage gehalten werden kann. Daraus ergibt sich ein hohes Maß an Flexibilität bei der Verarbeitung unterschiedlicher Lötgüter.

In einer weiteren vorteilhaften Ausbildung weist die Lötzone einen ersten Bereich zur Bereitstellung des ersten Volumenstromes und einen zweiten Bereich zur Bereitstellung des zweiten Volumenstromes auf. Durch die Aufteilung der Lötzone in mindestens einen ersten Bereich und mindestens einen zweiten Bereich lassen sich der erste und der zweite Volumenstrom jeweils unabhängig voneinander einstellen, wobei ein hohes Maß an Flexibilität bei einer eventuell notwendigen Änderung des Prozessablaufes auf Grund einer Änderung des Lötgutes gegeben ist, wie dies zuvor dargelegt ist. Insbesondere können bei einer Anlage in der der erste Bereich und der zweite Bereich jeweils von separat betriebenen Heizeinrichtungen versorgt werden, sehr viel raschere Anpassungen an neue Lötgüter erreicht werden, als dies bei der eingangs beschriebenen temperaturgesteuerten Lötanlage der Fall ist, wobei dennoch in hohem Maße gewährleistet ist, dass kleine Bauteile nicht überhitzt werden, auch wenn die Temperatur des Volumenstroms im zweiten Bereich gleich oder höher als die Temperatur des Volumenstroms im ersten Bereich ist, da der Wärmetransfer eben wirksam durch die Größe des Volumenstroms und im Wesentlichen nicht durch die Temperaturdifferenz zwischen Lötgut und Volumenstrom gesteuert wird.

In einer weiteren bevorzugten Ausführungsform wird der Volumenstrom stationär verringert. D. h., der Volumenstrom und damit die Temperatur, die an den Bauelementen des Lötgutes erzeugt wird, kann eingestellt werden, indem der Volumenstrom ohne Transport des Lötgutes zumindest zeitweilig verringert wird. Beispielsweise kann in einer Anfangsphase, sobald das Lötgut sich in der Lötzone befindet, dieses mit einem relativ hohen Volumenstrom beaufschlagt werden, der dann ohne Transport des Lötgutes kontinuierlich oder auch schrittweise reduziert wird, um damit eine kritische Temperatur bei kleinen Bauteilen nicht zu überschreiten. Obwohl bei einer Änderung des Volumenstromes, wie zuvor erläutert wurde, dessen tatsächliche Temperatur sich in Abhängigkeit der Bauart und der Steuerungsweise der zugeordneten Konvektionsheizeinrichtung verändern kann, ermöglicht die Steuerung des Volumenstromes, die in sehr präziser Weise, beispielsweise durch die Steuerung der Drehzahl eines entsprechenden Lüftermotors, verstellbar ist, ein gewünschtes Temperaturprofil auf dem Lötgut zu erzielen. Insbesondere kann bei Bedarf der gesamte Lötvorgang auf Grund der Steuerung des Volumenstromes in einer einzelnen Lötzone stattfinden, oder bei Vorsehen mehrerer Bereiche in der Lötzone kann somit ein sehr feinfühliges Temperatursteuem an den Bauelementen des Lötgutes stattfinden. Beispielsweise kann in einem ersten Lötbereich ein anfänglicher hoher Volumenstrom entsprechend einem gewünschten Zeitverhalten so reduziert werden, dass damit lediglich eine geringfügige Temperaturänderung des Volumenstromes auf Grund der Trägheit des Heizelements verknüpft ist, wobei dann in einem zweiten Lötbereich ein nochmals geringerer Volumenstrom bereitgestellt werden kann, der dann in gewissem Maße geregelt werden kann.

In einer weiteren vorteilhaften Ausführungsform kann ein Teil des ersten Volumenstromes vor Eintritt in die Lötzone abgezweigt werden, um mit dem restlichen Anteil des ersten Volumenstromes den zweiten Volumenstrom zu erzeugen. Durch diese Art der Regelung des ersten und des zweiten Volumenstromes kann die tatsächliche Temperatur der Volumenströme im Wesentlichen konstant gehalten werden, da die Belastung einer entsprechend zugeordneten Konvektionsheizeinrichtung im Wesentlichen konstant bleibt und sich nur das Verhältnis der entsprechenden Teile zur Bildung des zweiten Volumenstromes ändern.

In einer weiteren Ausführungsform kann der abgezweigte Anteil des ersten Volumenstromes zum Vorheizen eines weiteren Lötgutes verwendet werden, so dass sich ein hohes Maß an Energieausnutzung erreichen lässt.

In einer weiteren vorteilhaften Ausführungsform umfasst das Verfahren das Wählen einer maximal zulässigen Temperatur des Lötgutes und das Einstellen der Temperatur des verringerten Volumenstromes auf die gewählte maximal zulässige Temperatur. Durch diese Maßnahme lässt sich erreichen, dass in der Phase, in der kleine Bauelemente bereits eine relativ hohe Temperatur erreicht haben während der anfänglichen Beaufschlagung mit einem hohen Volumenstrom, in der weiteren Beaufschlagung mit dem reduzierten Volumenstrom eine Überschreitung der maximal zulässigen Temperatur nicht stattfinden kann. Bei einem stationären Variieren des Volumenstromes kann, wie zuvor erläutert wurde, bei hohem Anfangsvolumenstrom dessen effektive Temperatur absinken auf Grund der Trägheit des zugeordneten Konvektionsheizelements, wobei dennoch eine rasche Temperaturerhöhung kleiner und in etwas verzögerter Weise großer Bauelemente stattfindet. Durch die Reduzierung des Volumenstromes kann dann unter Umständen dessen effektive Temperatur ansteigen, wobei das Festlegen der Temperatur des verringerten Volumenstromes auf eine maximal zulässige Temperatur dann in jedem Falle sicherstellt, dass diese Temperatur bei den Bauelementen nicht überschritten wird.

In einer weiteren Ausführungsform wird auch die vorgegebene Temperatur, d. h. die Temperatur des anfänglichen hohen Volumenstromes auf die maximal zulässige Temperatur eingestellt. Damit wird erreicht, dass während des gesamten Lötvorgangs diese maximal zulässige Temperatur nicht überschritten wird, wobei in der Regel eine Temperaturprofilierung deutlich unter dieser maximal zulässigen Temperatur wünschenswert ist. Diese gewünschte Temperaturprofilierung wird, um die thermische Belastung der Bauelemente gering zu halten, dann durch die gezielte Volumenstromreduzierung tatsächlich aus dem Lötgut erreicht. Auf Grund sich ändernder Lötgüter kann die effektive Temperaturverteilung auf dem Lötgut variieren, wobei dennoch sichergestellt ist, dass eben die maximal zulässige Temperatur, unabhängig von der Art des zu bearbeitenden Lötgutes, nicht überschritten wird. Insbesondere kann bei einem Lötgut, das sehr viele große und damit träge Bauelemente enthält, der anfängliche Volumenstrom sehr hoch gewählt werden, beispielsweise bis an die Grenze der mechanischen Festigkeit, die durch die Lotpaste verliehen wird, so dass eine rasche Temperaturerhöhung in dieser Phase erreicht wird, ohne dass eine selbst für kleine Bauteile kritische Temperatur überschritten wird. Der anfänglich sehr hohe Volumenstrom kann dann vor der Verflüssigung der Lotpaste entsprechend reduziert werden, so dass die Fixierung der Bauteile auf der Lotpaste während des Lötvorganges sichergestellt bleibt.

In einer weiteren Ausführungsform wird die vorgegebene Temperatur unterhalb einer für bestimmte Bauelemente kritischen Temperatur gehalten und die Temperatur des Volumenstromes wird nach dessen Verringerung erhöht. Auf diese Weise wird in der Anfangsphase mit dem hohen Volumenstrom, in der ein rascher Temperaturanstieg insbesondere der großen Bauelemente stattfinden soll, gewährleistet, dass eine für bestimmte Bauelemente, beispielsweise kleine Halbleiterelemente, kritische Temperatur keinesfalls überschritten wird. In der nachfolgenden Phase mit dem verringerten Volumenstrom kann dann die Temperatur sogar erhöht werden, wobei der geringe Volumenstrom eine Überhitzung der kleine Bauteile effizient verhindert. Wie zuvor erläutert ist, kann eine entsprechende Temperaturerhöhung zumindest zeitweilig durch eine entsprechende Trägheit eines Konvektionsheizelementes hervorgerufen werden, die dann jedoch durchaus vorteilhaft für die weitere Temperaturprofilierung des Lötgutes ausgenutzt werden kann und durch die Regelung des Volumenstromes dennoch in einem für kleine Bauteile unkritischen Bereich gehalten werden kann.

Gemäß einem weiteren Aspekt der vorliegenden Erfindung umfasst ein Verfahren zum Löten eines Lötgutes in einem Durchlaufofen die folgenden Schritte. Zunächst wird das Lötgut bis auf eine Temperatur unterhalb des Schmelzpunktes eines Lotes aufgeheizt. Danach wird das Lötgut mit einer ersten über der Schmelztemperatur liegenden Temperatur mittels eines Volumenstroms beaufschlagt. Anschließend wird das Lötgut mit einer zweiten, über der Schmelztemperatur liegenden Temperatur, die kleiner als die erste Temperatur ist, beaufschlagt, wobei der Volumenstrom geändert wird.

Erfindungsgemäß kann also die Temperaturprofilierung auf einem Lötgut, die durch Beaufschlagen mit einer ersten hohen Temperatur und einer zweiten niedrigeren Temperatur in der Lötphase stattfindet, wie dies beispielsweise im einleitenden Teil beschrieben ist, deutlich verbessert werden, indem die Temperaturprofilierung mittels einer geeigneten Änderung des Volumenstroms, der zur Beaufschlagung des Lötgutes verwendet wird, präziser und flexibler gestaltet wird. So kann beispielsweise mit Hilfe eines moderaten Volumenstroms bei einer relativ hohen Eingangstemperatur ein entsprechend hoher Temperaturunterschied zwischen dem Volumenstrom und dem Lötgut erzielt werden, wodurch eine rasche Erwärmung sowohl kleiner als auch großer Bauteile erfolgt. Durch eine entsprechende zeitliche Bemessung der Beaufschlagung mit der ersten Temperatur kann eine übermäßige Erhitzung der sich schnell erwärmenden kleinen Bauelemente verhindert werden, indem das Lötgut nun mit einer zweiten geringeren, jedoch über der Schmelztemperatur liegenden Temperatur beaufschlagt, wobei der Volumenstrom eine entsprechende Temperaturprofilierung auf dem Lötgut deutlich verbessern kann, da insbesondere die Wärmeübertragung aus dem Volumenstrom auf das Lötgut von den Strömungsverhältnissen in unmittelbarer Nähe des Lötgutes abhängen kann. Z. B. ist es in einer Variante möglich, bei der ersten, also hohen Temperatur, einen relativ geringen Volumenstrom zu erzeugen, da beispielsweise eine relative laminare Strömung an Bereichen auftreten kann, die im Wesentlichen nur kleine Bauteile aufweisen. Die laminare Strömung führt zu einem ineffizienteren Wärmeübertrag als eine entsprechende turbulente Strömung, die durch großvolumige Bauelemente erzeugt wird. Infolgedessen kann der Wärmeübertrag an großvolumige Bauelemente überproportional höher sein im Vergleich zu kleinen Bauelementen, wenn diese in Bereichen des Lötgutes angeordnet sind, die von den Turbulenzen wenig beeinflusst werden. Bei der nachfolgenden Beaufschlagung mit der geringeren zweiten Temperatur, kann dann der Volumenstrom entsprechend erhöht werden, so dass sich insgesamt die Wärmeübertragung auf das Lötgut deutlich erhöht, so dass sich dann die großvolumigen Bauelemente weiterhin rasch erwärmen, während die Temperatur der kleinen Bauelemente sich maximal auf die zweite Temperatur erhöhen kann und somit eine unzulässige Überhitzung dieser kleinen Bauelemente ausgeschlossen ist. Ferner kann durch den verbesserten Wärmeübergang in dem erhöhten zweiten Volumenstrom ein kleines Bauelement, das unter Umständen eine zu rasche Erwärmung während der anfänglichen Phase erlitten hat, in sehr effizienter Weise auf die zweite Temperatur "abgekühlt" und somit in einem für das Bauteile unkritischen Bereich überführt werden.

In anderen Situationen kann es vorteilhaft sein, das Aufheizen des Lötgutes in der Anfangsphase mittels eines hohen Volumenstroms zu unterstützen, wobei in der nachfolgenden Lötphase mit der zweiten geringeren Temperatur ein geringerer Volumenstrom vorgesehen wird, der beispielsweise eine mechanische Fixierung der kleinen Bauteilen sicherstellt, wobei dennoch auf Grund der stärker turbulenten Strömung an großvolumigen Bauelementen eine weitere Erwärmung dieser Bauelemente ermöglicht.

Mit Bezug zu den begleitenden Zeichnungen werden nunmehr weitere anschauliche Ausführungsbeispiele detaillierter beschrieben. In den Zeichnungen zeigen:
- Fig. 1a: schematisch einen Durchlaufofen, der erfindungsgemäß so betrieben wird, dass ein Volumenstrom in einer ersten Phase höher als in einer zweiten Phase ist, wobei die Temperatur für beide Volumenströme in etwa gleich bleibt;
- Fig. 1b: einen Durchlaufofen, bei welchem ein Volumenstrom bei relativ konstanter Temperatur von einem anfänglich hohen Wert kontinuierlich abgesenkt wird, wobei die Änderung des Volumenstroms beispielsweise in stationärer Weise, d. h. ohne Transport des Lötgutes, stattfinden kann;
- Fig. 2a: einen Durchlaufofen, in welchem eine hohe erste Temperatur in einem ersten Lötbereich und eine niedrigere zweite Temperatur in einem zweiten Lötbereich aufrecht erhalten wird, wobei erfindungsgemäß der Volumenstrom geändert wird und in dem dargestellten Beispiel höher eingestellt ist als der Volumenstrom mit der hohen Temperatur;
- Fig. 2b: zeigt in beispielhafter Weise den Temperaturverlauf eines kleinen Bauteils und eines großen Bauteils, wenn diese mit der Vorrichtung aus Fig. 2a prozessiert werden;
- Fig. 3: eine erfindungsgemäße Vorrichtung, die ein steuerbares Gasführungssystem umfasst, um damit in effizienter Weise steuerbar mehrere Volumenströme mit spezifizierter Temperatur für mehrere Zonen eines Durchlaufofens zu erzeugen; und
- Fig. 4: schematisch ein Verfahren zur Steuerung der Änderung eines Volumenstroms in Abhängigkeit der optischen Eigenschaften eines gewissen Bereichs eines Lötgutes.

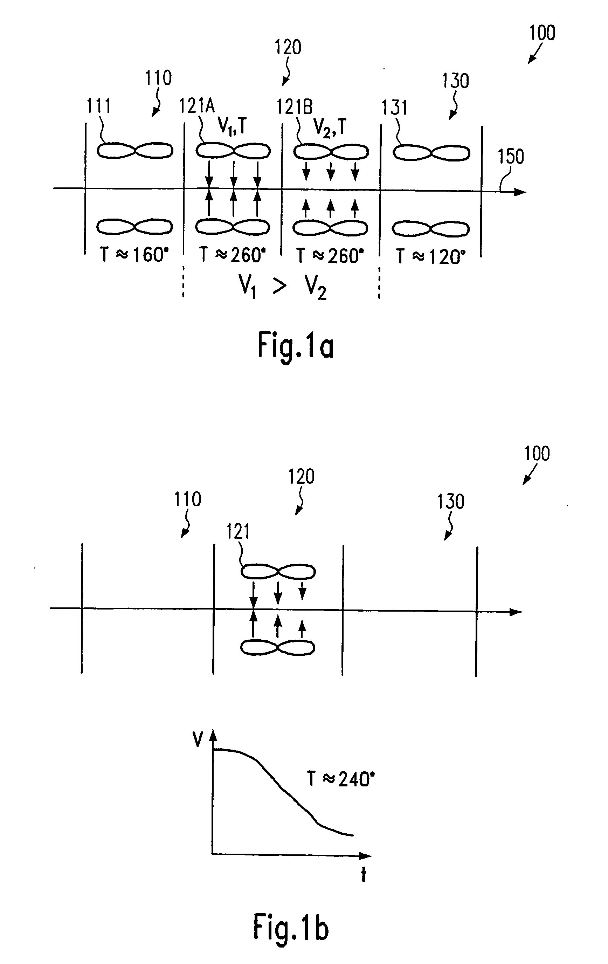

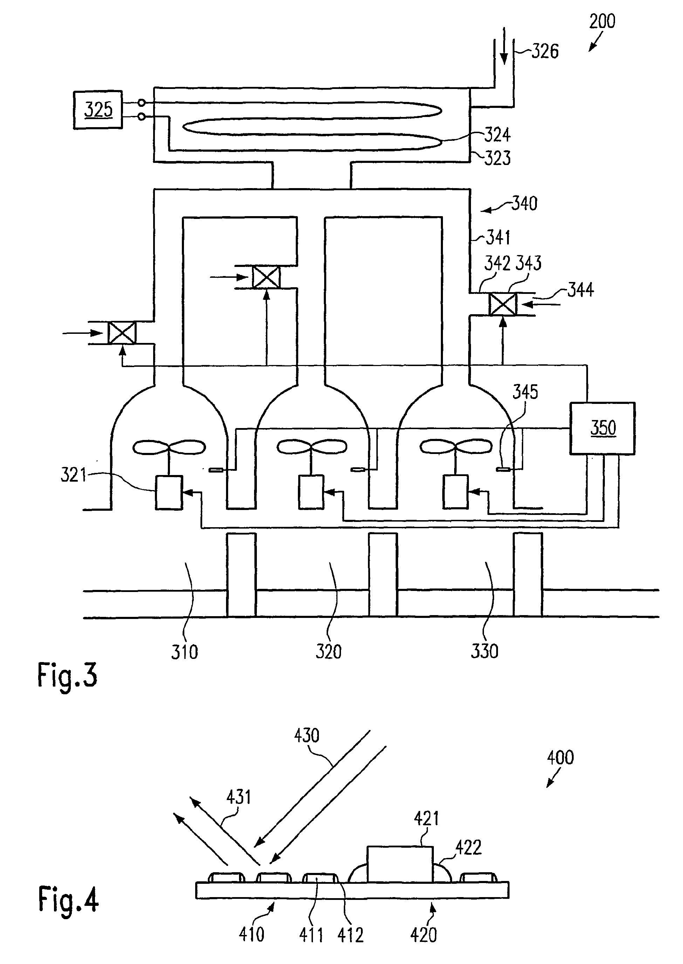

Fig. 1 a zeigt schematisch ein Beispiel einer Vorrichtung zum Aufschmelzlöten in Form eines Durchlaufofens 100, der in dem dargestellten Beispiel zumindest eine Vorheizzone 110, eine Lötzone 120 und eine Abkühlzone 130 umfasst. Ferner ist eine Transportvorrichtung 150 vorgesehen, die ein Lötgut (nicht gezeigt), beispielsweise in Form einer Elektronikplatine mit diversen darauf mittels einer Lotpaste angebrachten Bauelementen vorgesehen sein kann, durch die einzelnen Zonen 110, 120 und 130 befördert. Die Lötzone 120 ist in dem dargestellten Beispiel in zwei Bereiche 120a und 120b unterteilt, wobei in dem Bereich 120a mittels einer ersten Konvektionsheizeinheit 121a ein vorbestimmter Volumenstrom heißen Gases mit einer spezifizierten Temperatur T auf die Transporteinheit 150 und ggf. auf ein darauf sich befindliches Lötgut gerichtet wird. In ähnlicher Weise umfasst der Lötbereich 120b eine Konvektionsheizeinheit 121 b, die einen vordefinierten Volumenstrom heißen Gases mit einer spezifizierten Temperatur T auf die Transporteinrichtung 150 bzw. ein darauf befindliches Lötgut richtet. In der gezeigten Ausführungsform sind die Konvektionsheizelemente 121a, 121 b so ausgebildet, um das Lötgut von beiden Seiten mit einem entsprechenden Volumenstrom mit der gegebenen Temperatur zu beaufschlagen. In anderen Ausführungsbeispielen können die Konvektionsheizelemente 121 a, 121 b so ausgebildet sein, um lediglich eine Seite eines Lötguts mit einem Volumenstrom spezifizierter Temperatur zu beaufschlagen. Ferner ist es möglich, eine Vielzahl von Lötbereichen 120a, 120b in der Lötzone 120 vorzusehen, wobei diese dann mit entsprechenden Konvektionsheizelementen 121a, 121b ausgestattet sind, so dass eine an der Transportvorrichtung 150 wirksame Temperaturprofilierung eines sich darauf befindlichen Lötgutes in gewünschter Weise einstellbar ist. Ferner weist die Vorheizzone 110 eine entsprechende Konvektionsheizeinrichtung 111 und ggf. die Abkühlzone 130 ebenfalls eine entsprechende Konvektionsheizeinrichtung 131 auf. In anderen Ausführungsformen können die Vorheizzone 110 und/oder die Abkühlzone 130 einen oder mehrere Bereiche mit jeweils separaten Konvektionsheizeinrichtungen umfassen. Des weiteren können die Konvektionsheizeinrichtungen 121a, 121 b und ggf. die Heizeinrichtungen 111 und 131 separate Heizelemente aufweisen, um ein entsprechendes Prozessgas, beispielsweise Luft geeignet zu erhitzen, um damit dann mit entsprechenden Lüfterelementen einen vordefinierten Volumenstrom mit einer gewissen Temperatur in den einzelnen Zonen bereitzustellen. In anderen Ausführungsformen, wie dies beispielsweise später mit Bezug zu Fig. 3 beschrieben wird, können die Heizeinrichtungen ein zentrales Heizelement und ein entsprechend ausgeführtes Gasführungssystem aufweisen, um die Volumenströme mit erforderlicher Größe und Temperatur in den einzelnen Zonen bereitzustellen. Insbesondere können die einzelnen Zonen 110, 130 und die Bereiche 120a, 120b in identischer Weise ausgeführt sein, wobei sich deren Funktion durch die Wahl der Größe des Volumenstroms sowie dessen Temperatur ergibt.

Beim Betrieb der Vorrichtung 100 wird mittels der Transporteinrichtung 150 ein Lötgut, das in der Regel Bauelemente mit unterschiedlicher Größe aufweist, in die Vorheizzone 110 eingebracht und wird dort relativ langsam auf eine Temperatur von beispielsweise 160° C so aufgeheizt, dass eine im Wesentlichen gleichmäßige Temperaturverteilung auf dem Lötgut vorherrscht, d. h. dass die kleinen Bauteile sowie die großen Bauteile im Wesentlichen die gleiche Temperatur zeigen. Wie eingangs erläutert ist, kann dieser langsame und damit relativ gleichmäßige Aufheizvorgang nicht bis zur Schmelztemperatur der Lotpaste durchgeführt werden, da Aktivatoren in der Lotpaste vorzeitig ihre Wirkung entfalten und verbraucht werden und es zusätzlich zu einer Oxidation der Lötkontakte kommt. Danach wird das Lötgut mittels der Transporteinrichtung 150 in die Lötzone 120, d. h. in dem dargestellten Ausführungsbeispiel in den ersten Bereich 120a transportiert, wobei die gesamte Verweildauer in der Lötzone 120 deutlich unter 60 Sekunden bleiben soll, um somit einwandfreie Lötstellen zu erzeugen. In der dargestellten Ausführungsform ist die Heizeinrichtung 121a so eingestellt, dass ein Volumenstrom V1 vordefinierter Größe mit einer spezifizierten Temperatur, beispielsweise von 260° C auf das Lötgut einwirkt. Die Größe des Volumenstrom V1 ist dabei so gewählt, dass eine hohe Temperatur in der Nähe des Lötgutes wirksam ist, so dass eine rasche Aufheizung des Lötgutes über die Schmelztemperatur der Lotpaste hinweg erreicht wird. Auf der Grund der relativ hohen Temperatur sowie des hohen Volumenstromes findet eine sehr rasche Temperaturerhöhung der kleinen Bauteile statt, während die größeren Bauelemente mit etwas geringerer Geschwindigkeit an Temperatur zunehmen. Nach einer spezifizierten Verweilzeit, die in typischen Prozessdurchläufen zwischen 5 und 40 Sekunden betragen kann, wird das Lötgut in den zweiten Bereich 120b transportiert, in welchem ein deutlich geringerer Volumenstrom V2 bei etwa der gleichen Temperatur, z. B. 260° C zu einer geringeren an dem Lötgut wirksamen Temperatur führt und damit eine Überhitzung der kleineren Bauteile verhindert, während sich die größeren Bauelemente nach wie vor weiter aufheizen und damit zuverlässig die Schmelztemperatur der Lotpaste überschreiten. Nach einer spezifizierten Zeitdauer, beispielsweise im Bereich von 15 bis 35 Sekunden, wird das Lötgut in die Abkühlzone 130 transportiert, in der es durch erzwungene Konvektion oder einfach durch natürliche Konvektion an Temperatur verliert. Durch die Verringerung des Volumenstroms V1 auf den Wert V2 bei relativ konstanter Temperatur kann somit in effizienter Weise eine Überhitzung kleiner Bauteile verhindert werden, wohingegen größere Bauelemente zumindest in dem Bereich 120b zuverlässig gelötet werden. Die zuvor genannten Zeitangaben und Temperaturwerte sind lediglich beispielhafter Natur und können entsprechend einem gewünschten Prozessablauf entsprechend anders gewählt werden. Beispielsweise kann es bei kritischen Bauelementen vorteilhaft sein, eine maximal zulässige Temperatur im Voraus auszuwählen und zumindest die Temperatur in dem Bereich 120b auf diese maximal zulässige Temperatur einzustellen, so dass keinesfalls ein Überschreiten dieser Temperatur während der längeren Lötphase für die großen Bauelemente überschritten wird. In anderen Ausführungsformen kann es vorteilhaft sein, diese maximal zulässige Temperatur auch im ersten Bereich 120a aufrecht zu erhalten, wobei dann eine entsprechend rasche Erwärmung des gesamten Lötgutes durch eine entsprechende Erhöhung des Volumenstromes V1 erzielt wird. Beispielsweise könnte eine maximal zulässige Temperatur von 220° C ermittelt worden sein für spezielle Bauteile, wobei dann ein entsprechend hoher Volumenstrom V1 erzeugt wird, um trotz der relativ geringen Temperatur ein rasches Überschreiten der Schmelztemperatur der Lotpaste zu erzielen. Da auch in diesem Falle die Lotpaste an kleinen Bauteilen sich auf Grund der schnelleren Temperaturzunahme zuerst verflüssigt, könnte ein entsprechend hoher Volumenstrom ein ungewünschtes Verfließen der Lotpaste hervorrufen, so dass eine entsprechende Reduzierung des Volumenstroms V1 auf einen geringeren Wert durchgeführt werden kann, bevor sich die Lotpaste an kleineren Bauelementen verflüssigt. Dieser Zeitpunkt kann experimentell, mittels einem oder mehreren Probedurchläufen ermittelt werden oder kann messtechnisch erfasst werden.

Fig. 4 zeigt beispielsweise ein Lötgut 400 in Form einer Elektronikplatine, die einen ersten Bereich 410 und einen zweiten Bereich 420 aufweist. In dem ersten Bereich 410 sind mehrere kleinere Bauelemente 411 angeordnet, die an der Grundplatine mittels einer Lotpaste 412 befestigt sind. In dem zweiten Bereich 420 ist ein großes Bauelement 421 mittels entsprechender Lotpastenbereiche 422 angeordnet. Bei der Beaufschlagung des Lötguts 400 mit einem hohen Volumenstrom V1 bei relativ geringer Temperatur werden auf Grund des großen Wärmeübertrags, der durch den hohen Volumenstrom V1 erzielt wird, die Bauelemente 411 und 421 rasch erwärmt, wobei jedoch die kleinen Bauelemente 411 rascher an Temperatur gewinnen und somit die Schmelztemperatur für die Lotpaste 412 schneller erreicht wird. Bei Eintreten der Verflüssigung ändern sich u. a. die optischen Eigenschaften der Lotpaste 412, beispielsweise kann diese wesentlich reflektierender werden als im starren Zustand, so dass dadurch das Reflektionsverhalten eines auf dem ersten Bereich 410 einfallenden Lichtstrahls 430 ebenfalls geändert wird und diese Änderung in dem reflektierten Lichtstrahl 431 detektierbar ist. Sobald dann der reflektierte Lichtstrahl 431 eine entsprechende Änderung der Eigenschaften der Lotpaste 412 in dem Bereich 410 anzeigt, kann dann der Volumenstrom V1 in dem Bereich 120a auf einen Wert reduziert werden, der die flüssige Lotpaste 412 mechanisch im Wesentlichen nicht beeinflusst. Da die Größe des Volumenstroms beispielsweise durch die Drehzahl eines entsprechenden Lüfterelements in sehr kurzen Zeitbereichen, beispielsweise innerhalb von wenigen Millisekunden steuerbar ist, kann der Volumenstrom V1 selbst bei einem raschen Übergang zum geschmolzenen Zustand in dem Bereich 410 zurückgefahren werden, um damit eine ausreichende Fixierung der Bauteile aufrecht zu erhalten. Ferner wird auf Grund der relativ geringen Temperatur des Volumenstroms ein Überschreiten der zulässigen Temperatur effizient verhindert. Der weitere Lötvorgang kann dann so ausgeführt werden, wie dies zuvor beschrieben ist.

Fig. 1b zeigt schematisch eine weitere alternative Ausführungsform, in der der Volumenstrom relativ kontinuierlich geändert wird, beispielsweise auf der Grundlage eines Detektionssignals, das entsprechend dem zuvor mit Fig. 4 beschriebenen Verfahren erhalten wird, wobei dann der gesamte Lötvorgang beispielsweise in einer einzelnen Lötzone stattfinden kann. In Fig. 1b weist daher die Vorrichtung 100 eine einzelne Lötzone 120 mit einer damit verknüpften Heizeinrichtung 121 auf, wobei der Volumenstrom so geregelt wird, dass ein gewünschtes Temperaturprofil in dem zu prozessierenden Lötgut erreicht wird. Beispielsweise kann beim Einbringen des Lötgutes in die Lötzone 120 eine relativ hohe Temperatur mit einem hohen Volumenstrom erzeugt werden, wobei dann der Volumenstrom kontinuierlich oder stufenweise herabgesetzt wird, beispielsweise bei konstanter Temperatur, so dass größere Bauteile nach wie vor erhitzt werden, wohingegen die kleineren Bauelemente im Wesentlichen nicht mehr an Temperatur zunehmen.

Die Regelung der effektiv wirksamen Temperatur an dem Lötgut, d.h. gemeint ist die Temperatur die im/am Lötgut erzeugt wird, mittels des Volumenstroms ermöglicht somit eine sehr feinfühlige Temperaturprofilierung am Lötgut innerhalb einer einzelnen Kammer, da die Drehzahl eines Elektromotors und damit der Volumenstrom in sehr feinfühliger und rascher Weise einstellbar ist. Ferner lässt sich auf diese Weise die im/an dem Lötgut erzeugte Temperatur mittels der Regelung des Volumenstroms in wirkungsvoller Weise mit einem Detektionssignal koppeln, was ansonsten bei einer rein Temperatur gesteuerten Profilierung des Lötvorganges auf Grund der Trägheit bei Temperaturänderung nicht durchführbar wäre. Das Schaubild in Fig. 1b zeigt einen typischen Verlauf des Volumenstroms V in Abhängigkeit der Zeit für beispielsweise eine Temperatur des Volumenstroms von 240°C, um einen Lötvorgang in von 40 bis 60 Sekunden in der einzelnen Lötzone 120 zu erreichen.

Auf Grund der erfindungsgemäßen Regelung des Volumenstroms ist es nicht nur möglich, den Durchsatz eines Durchlaufofens zu erhöhen, indem lediglich eine Lötzone vorgesehen werden kann, sondern es kann auch in rascher Weise eine Änderung des Prozessablaufes erfolgen, d. h. eine Änderung der Prozesstemperaturen, sowie der Volumenströme, da der effektive Wärmeübertrag im Wesentlichen durch die Steuerung des Volumenstroms und nur in zweiter Linie durch die eigentliche Prozesstemperatur des Gases erreicht wird. Beispielsweise kann die Lötung eines Lötgutes mit deutlich mehr großvolumigen Bauelementen im Vergleich zu einem vorher prozessierten Lötgut es erforderlich machen, die Prozesstemperatur generell zu erhöhen, wobei die genaue Einhaltung einer bestimmten Temperatur nicht sehr kritisch ist, da der entsprechende Wärmeübertrag an das Lötgut im Wesentlichen durch den Volumenstrom steuerbar ist und damit in rascher und flexibler Weise an die neue Situation anpassbar ist. Zum Beispiel kann die Erhöhung der Prozesstemperatur für das neue Lötgut zu einer kürzeren Prozesszeit führen, wobei jedoch in der Phase des Aufheizens auf die neue Prozesstemperatur eine entsprechende Steuerung des Volumenstroms, beispielsweise durch ein Detektionssignal gesteuert, auch in dieser Übergangsphase zu korrekten Lötergebnissen führt.

In den zuvor beschriebenen Ausführungsformen ist die Prozesstemperatur bei Änderung des Volumenstroms als relativ konstant angenommen. In einigen Durchlauföfen sind die Heizeinrichtungen, etwa die Heizeinrichtungen 121a, 121b als separat steuerbare Konvektionsheizeinrichtungen vorgesehen, so dass eine Änderung des Volumenstroms, beispielsweise eine Verringerung des Volumenstroms zu einer Temperaturänderung, beispielsweise einer Temperaturerhöhung führen kann, da in diesem Falle weniger Wärme aus dem Heizelement entnommen wird und damit eine höhere Erwärmung des Prozessgases an dem Heizelement stattfinden kann. D. h. in einigen Ausführungsformen kann die Temperatur des reduzierten Volumenstroms höher sein als die Temperatur bei einem hohen Volumenstrom, was jedoch keinerlei negativen Auswirkungen auf den Lötvorgang ausübt, da ja der Volumenstrom so reduziert werden kann, dass die effektiv wirksame Temperatur an den kleinen Bauelementen unterhalb eines kritischen Bereiches lässt. In anderen Fällen kann diese höhere Temperatur sogar vorteilhafterweise ausgenutzt werden, indem der Volumenstrom so reduziert wird, dass die kleineren Bauelemente eine im Wesentlichen laminare Strömung erfahren, wobei der Wärmeübertrag stark eingeschränkt ist, und wobei die größeren Bauteile an ihren Oberflächen Turbulenzen hervorrufen, die weiterhin im Vergleich zu den kleineren Bauelementen einen höheren Wärmeübertrag und somit ein überproportionales Erwärmen ermöglichen, das in Kombination mit der generell erhöhten Prozesstemperatur des Volumenstroms insbesondere die größeren Bauelemente effizienter erwärmt.

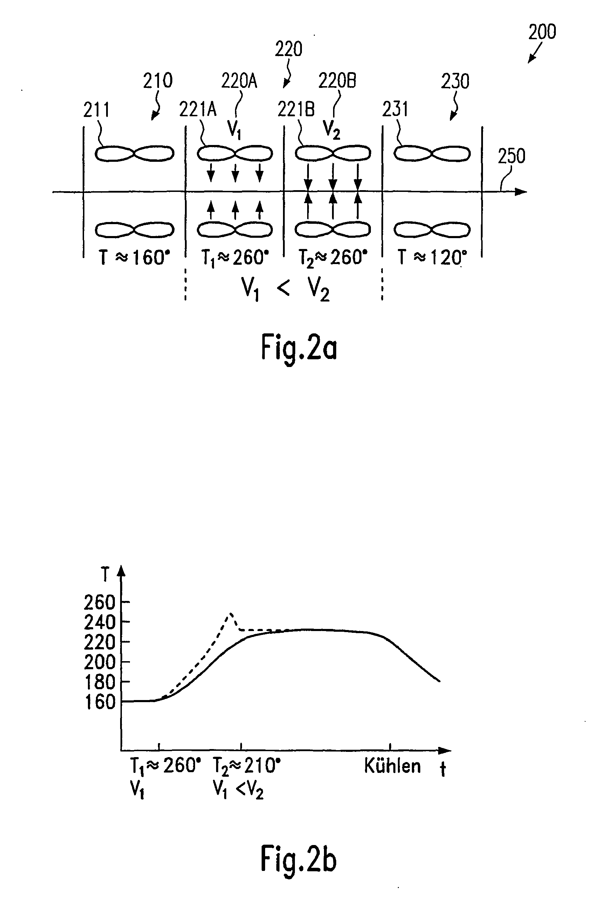

Fig.2a zeigt schematisch einen Durchlaufofen 200 mit einer Vorheizzone 210, einer Lötzone 220, die einen ersten Bereich 220a und einen zweiten Bereich 220b aufweist, und mit einer Abkühlzone 230. Die einzelnen Zonen 210, 220 und 230 umfassen entsprechende Konvektionsheizeinrichtungen 211, 221 a, 221 b und 231, die in ähnlicher Weise aufgebaut sein können, wie dies mit Bezug zu Fig. 1 a beschrieben ist.

Beim Betrieb des Durchlaufofens 200 sind insbesondere die Heizeinrichtungen 221 a und 221 b so eingestellt, dass die Prozesstemperatur, d. h. die Temperatur des Prozessgases auf einen relativ hohen Wert, beispielsweise 280° C eingestellt und entsprechend einem ersten moderaten Volumenstrom V1 auf ein entsprechendes Lötgut gerichtet wird, während die Prozesstemperatur in dem Bereich 220b deutlich kleiner aber dennoch über der Schmelztemperatur der Lotpaste liegt, beispielsweise bei 210°C. Dabei wird jedoch der Volumenstrom V2 mit der Temperatur 210° C deutlich erhöht im Vergleich zu dem Volumenstrom V1 in dem Bereich 220a. Bei Eintritt eines Lötgutes in den Bereich 220a wird auf Grund der hohen Prozesstemperatur ein rasches Aufheizen kleiner und großer Bauteile bewerkstelligt, wobei die Verweildauer in dem Bereich 220a so kurz bemessen ist, dass keine Überhitzung der kleineren Bauteile, die sich rascher erwärmen als die großen Bauteile, erfolgt. Das Lötgut wird nun in den zweiten Bereich 220b transportiert und dort der geringeren Temperatur T2 ausgesetzt, wobei jedoch der Volumenstrom V2 deutlich erhöht ist, so dass auf Grund des erhöhten Volumenstroms weiterhin eine effiziente Aufheizung der größeren Bauteile erfolgt, während die kleineren Bauteile auf der Temperatur T2 gehalten oder rasch auf diese eingestellt werden.

Fig. 2b zeigt ein beispielhaftes Temperaturprofil für ein kleines Bauteil, das durch die gestrichelte Linie repräsentiert ist, und ein großes Bauteil, das durch die durchgezogene Linie repräsentiert ist. Nach dem Eintritt in den Bereich 220a mit der Prozesstemperatur von beispielsweise 280° C und einem moderaten Volumenstrom V1 findet eine rasche Erwärmung des kleinen Bauteils auf eine Temperatur von etwa 230° C statt, wohingegen das große Bauelement eine Endtemperatur in dem Bereich 220a von etwa 200° C aufweist. Nach Einbringen des Lötgutes in den Bereich 220b fällt die Temperatur des kleinen Bauelements rasch ab auf Grund der "kühlenden Wirkung" des hohen Volumenstroms mit der kleineren Temperatur und bleibt dann auf diesem unkritischen Temperaturniveau konstant. Demgegenüber nimmt die Temperatur des großen Bauteils trotz der geringeren Prozesstemperatur dennoch schnell zu, da der hohe Volumenstrom V2 einen effizienten Wärmeübertrag auf die Bauteile ermöglicht. Durch die Änderung des Volumenstroms bei den vorgegebenen Temperaturen kann im Gegensatz zu dem eingangs beschriebenen Verfahren eine kürzere Prozesszeit und/oder eine höhere Zuverlässigkeit erreicht werden, da durch die Volumenstromerhöhung bei niedriger Temperatur zuverlässig kleine Bauelemente auf eine unkritische Temperatur kühlt, die daher sehr hoch gewählt werden kann, zunächst hervorgerufen wird.

In anderen Ausführungsformen kann es vorteilhaft sein, den Volumenstrom bei einer hohen Anfangstemperatur entsprechend hoch zu wählen, um damit ein sehr schnelles Aufheizen zu ermöglichen und dann eine deutlich geringere Prozesstemperatur anzuwenden, wobei dann auch ein reduzierter Volumenstrom eingestellt wird, um den Wärmeübergang für kleine Bauelemente wirksam zu reduzieren und gleichzeitig die größeren Bauelemente, die eine turbulentere Strömung hervorrufen können, weiterhin effizient zu erwärmen.

Fig. 3 zeigt schematisch eine weitere Ausführungsform einer Vorrichtung zum Aufschmelzlöten, die in Form eines Durchlaufofens 300 repräsentiert ist, wobei diese ferner eine Steuereinheit 350 umfasst, um damit den Volumenstrom und die Prozesstemperatur insbesondere in der mit Bezug zu den Fig. 1a und 1b beschriebenen Weise zu steuern. Des weiteren umfasst die Vorrichtung 300 eine Heizeinrichtung 323 mit darin angebrachten Heizschlangen 324, die beispielsweise elektrisch mittels einer entsprechenden Stromversorgung 325 betrieben werden. Des weiteren ist ein Anschluss 326 für die Zuführung eines Prozessgases, beispielsweise Luft, Stickstoff und dergleichen vorgesehen. Die Heizeinrichtung 323 ist mit einem Gasführungssystem 340 verbunden, das wiederum mit einer oder mehreren elektrisch angetriebenen Lüftereinrichtungen 321 gekoppelt ist. Das Gasführungssystem 340 umfasst eine oder mehrere Heißgasleitungen 341, die mit der Heizeinrichtung 323 gekoppelt sind, und umfasst entsprechend viele Prozessgaszufuhrleitungen 342, die mittels eines steuerbaren Ventilelements 343 mit einer Quelle kühleren Prozessgases 344 verbunden sind. Des weiteren sind Temperatursensoren 345 vorgesehen und so angebracht, um die Temperatur eines Volumenstroms zu erfassen, der in eine entsprechende Zone der Vorrichtung 300 zugeführt wird. Die elektrisch angetriebenen Lüftereinrichtungen 321, die steuerbaren Ventilelemente 343 sowie die Temperatursensoren 345 sind mit der Steuereinrichtung 350 verbunden.

Beim Betrieb der Vorrichtung 300 wird mittels der Stromversorgung 325 den Heizelementen 324 ausreichend Energie zugeführt, um damit ein über die Leitung 326 zugeführtes Prozessgas in ausreichender Menge auf eine hohe Temperatur, beispielsweise 300° C oder mehr zu erhitzen. Durch die Steuereinheit 350 wird mittels Einstellen einer gewünschten Drehzahl ein entsprechender Volumenstrom abhängig von einem gewünschten Betriebsrezept in den jeweiligen Zonen der Vorrichtung 300 erzeugt, wobei mittels der Temperatursensoren 345 die Temperatur des entsprechenden Volumenstromes gemessen und den Messergebnissen entsprechend die steuerbaren Ventilelemente 343 so eingestellt werden, um durch eine geeignete Ventilstellung eine Mischung des heißen Prozessgases aus dem Heizelement 323 und des kühleren Prozessgases, das durch die Leitung 344 zugeführt wird, mit der gewünschten Temperatur zu erhalten. Auf diese Weise kann in effizienter Weise die Prozesstemperatur bei veränderlichem Volumenstrom konstant gehalten oder entsprechend den Prozesserfordernissen rasch geändert werden. Beispielsweise können die einzelnen Zonen 310, 320, 330 jeweils einer Lötzone entsprechen, in der gleichzeitig drei Lötgüter prozessiert werden, wobei in jeder der Zonen entsprechend dem gewünschten Prozessrezept oder entsprechend erhaltener Detektionssignale von dem Lötgut der Volumenstrom und die Prozesstemperatur in der zuvor beschriebenen Weise eingestellt werden kann. In anderen Ausführungsformen können die Zonen 310, 320 und 330 einer Vorheizzone einer Lötzone und einer Abkühlzone entsprechen, wobei ein Lötgut der Reihe nach in diese Zonen transportiert und entsprechende Volumenströme und Temperaturen in den Zonen eingestellt werden. Insbesondere kann bei unterschiedlichen Volumenströmen beispielsweise in der Lötzone 320 der bei einem Übergang von einem hohen Volumenstrom zu einem niedrigen Volumenstrom nicht mehr benötigte Anteil an Prozessgas in effizienter Weise in anderen Zonen eingesetzt werden. Andererseits kann bei einem momentanen hohen Bedarf in der Lötzone 320 der Volumenstrom in der Zone 310 und/oder 330 gedrosselt werden, beispielsweise bei gleichbleibender Temperatur, so dass die Heizeinrichtung 323 lediglich für den kontinuierlichen Betrieb, d. h. beispielsweise die Lötphase bei reduzierten Volumenstrom, ausgelegt sein muss und nicht ständig mit Energie entsprechend einer Spitzenbelastung bei einem kurzfristig erhöhten Volumenstrom ausgelegt sein muss. In anderen Ausführungsformen kann die Steuereinheit 350 zusätzlich mit einer entsprechenden Detektionsanlage, beispielsweise einer optischen Detektionsanlage, die eine Änderung optischer Eigenschaften gewisser Bereiche des Lötgutes detektieren kann, verbunden sein, um damit den Lötprozess auf der Grundlage der gewonnen Detektionssignale zu steuern. Das Vorsehen der Steuereinheit 350 im Zusammenwirken mit dem erfindungsgemäßen Prinzip der Änderung des Volumenstromes zur Steuerung des Temperaturprofils auf einem Lötgut ergibt, möglicherweise in Kombination mit einer entsprechenden Detektionsvorrichtung, eine äußerst flexible Vorrichtung zur Aufschmelzlötung, in der nicht nur ein hohes Maß an Zuverlässigkeit des Lötvorganges auf Grund der sehr gleichmäßigen Erwärmung großer und kleiner Bauelemente gewährleistet ist, sondern auch ein rascheres Anpassen an veränderte Prozessstrategien, beispielsweise auf Grund einer Änderung des Lötgutes, ermöglicht wird.

## Patentansprüche

1. Verfahren zum Löten eines Lötgutes in einem Durchlaufofen mit:
Aufheizen des Lötgutes in einer Vorheizzone mittels einer Vorheizeinrichtung auf eine vorgegbene erste Temperatur, die unter der Schmelztemperatur eines Lotes liegt, das mit dem Lötgut in Kontakt ist,
Beaufschlagung des Lötgutes in einer Lötzone mit einem ersten Volumenstrom eines Fluids mit einer über der Schmelztemperatur des Lotes liegenden vorgegebenen zweiten Temperatur, die mittels einer Konvektionsheizeinrichtung erzeugt wird, und
nach Beaufschlagung mit dem ersten Volumenstrom, Beaufschlagen des Lötgutes in der Lötzone mit einem zweiten Volumenstrom eines Fluids mit derselben zweiten Temperatur, wobei der erste Volumenstrom größer als der zweite Volumenstrom ist,
und wobei die Konvektionsheizeinrichtung das Lötgut von beiden Seiten mit dem Volumenstrom mit der zweiten Temperatur beaufschlagt, und
Abkühlen des Lötgutes unter die Schmelztemperatur in einer Abkühlzone.

2. Verfahren nach Anspruch 1, wobei die Lötzone einen ersten Bereich zur Bereitstellung des ersten Volumenstroms und einen zweiten Bereich zur Bereitstellung des zweiten Volumenstroms aufweist.

3. Verfahren nach Anspruch 1, wobei der eine oder die zwei Volumenströme stationär verringert werden.

4. Verfahren nach Anspruch 2, wobei ein Teil des ersten Volumenstroms vor Eintritt in die Lötzone abgezweigt wird, um mit dem restlichen Anteil des ersten Volumenstroms den zweiten Volumenstrom zu erzeugen.

5. Verfahren nach Anspruch 4, wobei der abgezweigte Anteil des ersten Volumenstroms zum Vorheizen eines weiteren Lötgutes verwendet wird.

6. Verfahren nach einem der Ansprüche 1 bis 5, das ferner umfasst: Wählen einer maximal zulässigen Temperatur des Lötgutes und Einstellen der Temperatur des zweiten Volumenstroms auf die gewählte maximal zulässige Temperatur.

7. Verfahren nach Anspruch 6, wobei die vorgegebene Temperatur auf die maximal zulässige Temperatur eingestellt wird.

8. Verfahren nach Anspruch 2, wobei mindestens eine erste Konvektionsheizeinheit der Konvektionsheizeinrichtung in der ersten Lötzone und mindestens eine zweite Konvektionsheizeinheit der Konvektionsheizeinrichtung in der zweiten Lötzone vorgesehen sind.

9. Verfahren nach einem der Ansprüche 1 bis 8, wobei der erste Volumenstrom auf der Grundlage eines Detektionssignals, das von dem Lötgut erhalten wird, reduziert wird.

## Claims

1. A method of soldering a workpiece to be soldered in a continuous furnace, comprising:
heating the workpiece to be soldered in a preheating zone by means of a preheating device to a predetermined first temperature, which is below the melting temperature of a solder which is in contact with the workpiece to be soldered,
exposing the workpiece to be soldered in a soldering zone to a first stream of a fluid at a predetermined second temperature above the melting temperature of the solder, which temperature is generated by means of a convection heating device, and
after exposure to the first stream, exposing the workpiece to be soldered in the soldering zone to a second stream of a fluid at the same second temperature, wherein the first stream is larger in volume than the second stream,
and wherein the convection heating device exposes the workpiece to be soldered to the stream at the second temperature from both sides, and
cooling the workpiece to be soldered to below the melting temperature in a cooling zone.

2. A method according to claim 1, wherein the soldering zone comprises a first region for providing the first stream and a second region for providing the second stream.

3. A method according to claim 1, wherein the one or the two streams are steadily reduced in volume.

4. A method according to claim 2, wherein part of the first stream is branched off prior to entry into the soldering zone, in order to generate the second stream with the remaining portion of the first stream.

5. A method according to claim 4, wherein the branched-off portion of the first stream is used to preheat a further workpiece to be soldered.

6. A method according to any one of claims 1 to 5, which further comprises: selecting a maximum permissible temperature for the workpiece to be soldered and adjusting the temperature of the second stream to the selected maximum permissible temperature.

7. A method according to claim 6, wherein the predetermined temperature is adjusted to the maximum permissible temperature.

8. A method according to claim 2, wherein at least one first convection heating unit of the convection heating device is provided in the first soldering zone and at least one second convection heating unit of the convection heating device is provided in the second soldering zone.

9. A method according to any one of claims 1 to 8, wherein the first stream is reduced in volume on the basis of a detection signal, which is received from the workpiece to be soldered.

## Revendications

1. Procédé de brasage d'un article à braser dans un four continu comprenant les étapes consistant à :
chauffer l'article à braser dans une zone de préchauffage au moyen d'un équipement de préchauffage à une première température prédéfinie inférieure à la température de fusion d'un métal d'apport de brasage en contact avec l'article à braser,
soumettre l'article à braser dans une zone de brasage à l'influence d'un premier débit volumétrique d'un fluide présentant une seconde température prédéfinie supérieure à la température de fusion du métal d'apport de brasage et produite au moyen d'un appareil de chauffage par convection, et
après avoir soumis l'article à braser à l'influence du premier débit volumétrique, le soumettre dans la zone de brasage à l'influence d'un second débit volumétrique d'un fluide présentant la même seconde température, le premier débit volumétrique étant supérieur au second débit volumétrique,
et l'appareil de chauffage par convection soumettant les deux côtés de l'article à braser à l'influence du débit volumétrique présentant la seconde température, et
laisser refroidir l'article à braser à une température inférieure à la température de fusion dans une zone de refroidissement.

2. Procédé selon la revendication 1, la zone de brasage comprenant une première région destinée à mettre à disposition le premier débit volumétrique et une seconde région destinée à mettre à disposition le second débit volumétrique.

3. Procédé selon la revendication 1, l'un des débits volumétriques ou les deux débits volumétriques étant réduit(s) de façon stationnaire.

4. Procédé selon la revendication 2, une partie du premier débit volumétrique étant déviée avant d'entrer dans la zone de brasage afin de produire le second débit volumétrique avec la part restante du premier débit volumétrique.

5. Procédé selon la revendication 4, la part déviée du premier débit volumétrique étant utilisée pour préchauffer un autre article à braser.

6. Procédé selon l'une quelconque des revendications 1 à 5, comprenant en outre les étapes consistant à : sélectionner une température maximale admissible de l'article à braser et régler la température du second débit volumétrique à la température maximale admissible sélectionnée.

7. Procédé selon la revendication 6, la température prédéfinie étant réglée sur la température maximale admissible.

8. Procédé selon la revendication 2, au moins une première unité de chauffage par convection de l'appareil de chauffage par convection étant prévue dans la première zone de brasage et au moins une seconde unité de chauffage par convection de l'appareil de chauffage par convection étant prévue dans la seconde zone de brasage.

9. Procédé selon l'une quelconque des revendications 1 à 8, le premier débit volumétrique étant réduit sur la base d'un signal de détection reçu par l'article à braser.
